# EUROPÄISCHE PATENTANMELDUNG

(11) **EP 4 498 410 A2**
(43) Veröffentlichungstag der Anmeldung: **29.01.2025**
(21) Anmeldenummer: 24190840.9
(22) Anmeldetag: 25.07.2024
(51) Int. Cl.: H01L 21/66, B07C 5/00, G01R 27/02, G06F 18/24

(54) **TEST- UND QUALITÄTSKONTROLLVERFAHREN BEI DER HERSTELLUNG VON HALBLEITERBAUELEMENTEN**

(30) Priorität: 26.07.2023 DE 102023207153
(71) Anmelder: VOLKSWAGEN AG, 38440 Wolfsburg (DE)
(72) Erfinder: Arnaout, Samy, Tianjin, 300040 (CN); Kühnlenz, Florian, 38476 Barwedel (DE); Wachtendorf, Christian, 38126 Braunschweig (DE)

(57) **Zusammenfassung**

Die Erfindung betrifft ein Test- und Qualitätskontrollverfahren in einem Prozess zur Herstellung von Halbleiterbauelementen (Hₓ), etwa GaN, IGBT, Sic-MOSFET etc., mit einem Messschritt, bei dem die Größe eines Durchlasswiderstands (Rₓ) des jeweiligen Halbleiterbauelements (Hₓ) oder ein damit korrelierender Testparameter gemessen wird. Erfindungsgemäß weist das Test-und Qualitätskontrollverfahren einen Auswerteschritt aufweist, bei dem eine Abweichung (ΔR) des Testparameters (Rₓ) von seinem Nominalwert (R_{N}) bestimmt wird. In dem Auswerteschritt erfolgt eine Kategorisierung (K2), bei der basierend auf der Größe der Abweichung (ΔR) das jeweilige Halbleiterbauelement (Hₓ) einer Kategorie beziehungsweise einem Bin (B1, B2, B3) zugeordnet wird, die den weiteren Einsatz des Halbleiterbauelements (Hₓ) bestimmt.

## Beschreibung

Die Erfindung betrifft ein Test- und Qualitätskontrollverfahren in einem Prozess zur Herstellung von Halbleiterbauelementen nach dem Oberbegriff des Anspruches 1.

Die Hauptanwendung der Erfindung zielt insbesondere, jedoch nicht ausschließlich, auf Sic-MOSFETs ab, die in Pulswechselrichter verbaut werden.

Für die Herstellung von Halbleiterbauelementen wird ein Wafer bereitgestellt, der im Prozessverlauf zu Halbleiterbauelementen oder Chips vereinzelt wird, sodass die Halbleiterbauelemente separat voneinander weiterbearbeitet werden können. Die Halbleiterbauelemente weisen über den Wafer verteilt keine elektrisch konstanten Eigenschaften, das heißt keine konstanten elektrischen Kernwerte auf, sondern vielmehr eine Verteilung mit variierenden elektrischen Kennwerten, etwa variierende Gate-Schwellenspannungen und/oder variierende Durchlasswiderstände.

In einem gattungsgemäßen Test- und Qualitätskontrollverfahren, das in einem Prozess zur Herstellung von Halbleiterbauelementen eingebettet ist, wird ein Messschritt durchgeführt, bei dem die Größe eines Durchlasswiderstands des jeweiligen Halbleiterbauelements oder ein damit korrelierender Testparameter gemessen wird. Anschließend wird eine Kategorisierung durchgeführt, bei der basierend auf der Größe des gemessenen Testparameters (das heißt des Durchlasswiderstands) das jeweilige Halbleiterbauelement einer Kategorie beziehungsweise einem Bin zugeordnet wird. Dadurch sind jeweils Halbleiterbauelemente, deren Testparameter eine gleiche oder ähnliche Größen aufweisen, derselben Kategorie zugeordnet (sogenanntes Binning). Dies gewährleistet, dass in einem Leistungsmodul eines Pulswechselrichters eines elektrisch betriebenen Fahrzeugs Chips mit ähnlichen elektrisch Kennwerten zu einem Leistungsschalter parallelgeschaltet werden, sodass im Betrieb die Chips nahezu gleichzeitig schalten.

Bei der obigen Kategorisierung bleibt jedoch die Abweichung des Durchlasswiderstand des jeweiligen Halbleiterbauelements von seinem Nominalwert unberücksichtigt. Eine derartige Abweichung kann bis zu ±30 % vom Nominalwert betragen. Diese Abweichung vom Nominalwert muss bei der Chipauslegung berücksichtigt werden, da der Durchlasswiderstand die Leitverluste dominiert. Im Stand der Technik wird daher diese Abweichung insoweit berücksichtigt, als der Durchlasswiderstand des jeweiligen Halbleiterbauelements jeweils mit einem entsprechenden Sicherheitsaufmaß gekennzeichnet ist, das die Toleranz von ± 30 % berücksichtigt.

Aus der US 2019/0143374 A1 ist eine Chipsortier- und Verpackungsplattform bekannt, die ein Zufuhrmodul, ein Sortiermodul und ein Verpackungsmodul aufweist. Zufuhrmodul ist so ausgelegt, dass es eine Vielzahl von Chips zuführt. Das Sortiermodul ist so konfiguriert, dass es die vom Zufuhrmodul zugeführten Chips aufnimmt und bestimmt, ob jeder der Chips qualifiziert ist. Das Verpackungsmodul ist so konfiguriert, dass es qualifizierte Chips verpackt. Aus der CN 109470921 A ist ein Verfahren zum Erreichen einer hochgradigen Präzisionsanwendung auf der Basis von Widerständen mit geringer Genauigkeit bekannt. Aus der CN 113155193 A ist ein intelligentes Wafererkennungs- und Klassifizierungsverfahren bekannt, das auf Basis von Cloud Computing arbeitet. Das Verfahren weist unter anderem die folgenden Schritte auf: Ermitteln der Kapazitäts- und Spannungscharakteristik-Parameter von Wafern; Berechnen des Abweichungswiderstands der Wafer gemäß den kapazitiven und spannungsspezifischen Parametern.

Die Aufgabe der Erfindung besteht darin, ein Test- und Qualitätskontrollverfahren in einem Prozess zur Herstellung von Halbleiterbauelementen bereitzustellen, bei dem die Halbleiterbauelemente mit steuernden elektrischen Kennwerten optimal nach Performance und/oder Kosten einsetzbar sind.

Die Aufgabe ist durch die Merkmale des Anspruches 1 gelöst. Bevorzugte Weiterbildungen der Erfindung sind in den Unteransprüchen offenbart.

Die Erfindung geht von einem Test- und Qualitätskontrollverfahren in einem Prozess zur Herstellung von Halbleiterbauelementen aus. Die Hauptanwendung der Erfindung zielt insbesondere, jedoch nicht ausschließlich, auf Sic-MOSFETs ab, die in Pulswechselrichter verbaut werden. Das Test- und Qualitätskontrollverfahren weist einen Messschritt auf, bei dem die Größe eines Durchlasswiderstands des jeweiligen Halbleiterbauelements oder ein damit korrelierender Testparameter gemessen wird. Gemäß dem kennzeichnenden Teil des Anspruches 1 weist das Test- und Qualitätskontrollverfahren einen Auswerteschritt auf, bei dem eine Abweichung des Testparameters von seinem Nominalwert bestimmt wird. Im Auswerteschritt erfolgt eine Kategorisierung, bei der basierend auf der Größe der Abweichung das jeweilige Halbleiterbauelement einer Kategorie beziehungsweise einem Bin zugeordnet wird, die den weiteren Einsatz des Halbleiterbauelements bestimmt.

In einer technischen Umsetzung kann zur Durchführung der Kategorisierung ein Zuordnungsbaustein bereitgestellt sein, in dem für jedes Halbleiterbauelement die Abweichung des Testparameters vom Nominalwert ermittelt wird. Zudem wird im Zuordnungsbaustein der die Kategorisierung der Halbleiterbauelemente vorgenommen.

Beispielhaft kann folgende Kategorisierung im Zuordnungsbaustein durchgeführt werden: So können Halbleiterbauelemente, deren Abweichung bei -0,3 R_{N} < ΔR ≤ (-0,05) R_{N} liegt, einer ersten Kategorie beziehungsweise Bin zugeordnet werden. Halbleiterbauelemente, deren Abweichung bei -0,05 R_{N} < ΔR ≤ +0,05 R_{N} liegt, können einer zweiten Kategorie beziehungsweise Bin zugeordnet werden. Alternativ dazu können Halbleiterbauelemente, deren Abweichung bei +0,05 R_{N} < ΔR ≤ +0,3 R_{N} liegt, einer dritten Kategorie beziehungsweise Bin zugeordnet werden.

In einer konkreten Ausführungsvariante können die Halbleiterbauelemente, die der ersten Kategorie beziehungsweise Bin zugeordnet sind, in Leistungsmodulen mit Einsatz in Hochtemperaturländern verbaut werden. Alternativ dazu können Halbleiterbauelemente, die der zweiten Kategorie beziehungsweise Bin zugeordnet sind, in Leistungsmodulen mit Einsatz in gemäßigten Klimazonen verbaut werden. Alternativ dazu können Halbleiterbauelementen, die der dritten Kategorie beziehungsweise Bin zugeordnet sind, in Leistungsmodulen mit Einsatz in Niedrigtemperaturländern verbaut werden.

In einer zweiten konkreten Ausführungsform können Halbleiterbauelemente, die der ersten Kategorie beziehungsweise Bin zugeordnet sind, in Leistungsmodulen einer Hochstromvariante eines elektrisch betriebenen Fahrzeugs hoher Leistungsklasse verbaut werden. Halbleiterbauelemente, die der zweiten Kategorie beziehungsweise Bin zugeordnet sind, können dagegen in Leistungsmodulen eines Fahrzeugs mittlerer Leistungsklasse verbaut werden. Halbleiterbauelemente, die der dritten Kategorie beziehungsweise Bin zugeordnet sind, können in Leistungsmodulen eines elektrisch betriebenen Fahrzeugs geringer Leistungsklasse verbaut werden.

In einer dritten konkreten Ausführungsform können Halbleiterbauelemente, die der ersten Kategorie beziehungsweise Bin zugeordnet sind, in Pulswechselrichter verbaut werden. Halbleiterbauelemente, die der zweiten Kategorie beziehungsweise Bin zugeordnet sind, können dagegen in DC/DC-Wandler verbaut werden. Demgegenüber können Halbleiterbauelemente, die der dritten Kategorie beziehungsweise Bin zugeordnet sind, in Ladesäulen verbaut werden.

Jegliche Kombination von Halbleiterbauelementen im Pulswechselrichter von elektrisch betriebenen Fahrzeugen gleichen Fahrzeugtyps führt zu unterschiedlichen Leistungsangaben der Fahrzeuge. Die entsprechend gekennzeichneten unterschiedlichen Leistungsangaben können für den Fahrzeugkäufer als Kaufhilfe dienen.

In einer technischen Realisierung wird in dem erfindungsgemäßen Test- und Qualitätskontrollverfahren eine zweistufige Kategorisierung durchgeführt. Bei der zweistufigen Kategorisierung wird - zusätzlich zu oben beschriebenen Kategorisierung basierend auf der Abweichung des Testparameters von seinem Nominalparameter - eine weitere Kategorisierung durchgeführt, und zwar basierend auf der Größe des gemessenen Testparameters des jeweilige Halbleiterbauelements. In dieser weiteren Kategorie wird, basierend auf der Größe des gemessenen Testparameter, das jeweilige Halbleiterelement in eine Kategorie derart sortiert, dass die Halbleiterbauelemente, deren Testparameter gleiche oder ähnliche Größen aufweisen, derselben Kategorie zugeordnet sind.

Bevorzugt ist es, wenn in der oben genannten zweistufigen Kategorisierung die Kategorisierung basierend auf der Größe der gemessenen Testparameter eine Vor-Kategorisierung ist. Dieser Vor-Kategorisierung ist prozesstechnisch nachgeschaltet die Kategorisierung basierend auf der Größe der Abweichung vom Nominalwert, die als Folge-Kategorisierung durchführbar ist.

Nachfolgend ist anhand der Figur ein Ausführungsbeispiel der Erfindung beschrieben.

Für die Herstellung von in der Figur beispielhaft insgesamt 248 Halbleiterbauelementen H₁...H₂₄₈ wird ein Wafer bereitgestellt. Der Wafer wird im weiteren Prozessverlauf in die voneinander getrennten Halbleiterbauelemente H₁ bis H₂₄₈ aufgeteilt, sodass die Halbleiterbauelemente H₁...H₂₄₈ separat voneinander bearbeitet werden können. Die Halbleiterbauelemente H, bis H₂₄₈ weisen über den Wafer verteilt keine konstanten elektrischen Kernwerte auf, sondern vielmehr eine Verteilung mit variierenden elektrischen Kennwerten/Kernwerten, insbesondere mit variierenden Durchlasswiderständen R₁...R₂₄₈ sowie damit gekoppelten, variierenden Gate-Schwellenspannungen.

Damit die Halbleiterbauelemente H₁...H₂₄₈ optimal nach Performance und Kosten eingesetzt werden können, ist im Herstellungsprozess ein erfindungsgemäßes Test- und Qualitätskontrollverfahren eingebunden, das in der Figur anhand eines grob schematischen Blockschaltdiagramms insoweit veranschaulicht ist, als es für das Verständnis der Erfindung erforderlich ist.

Demnach erfolgt in dem Test- und Qualitätskontrollverfahren eine zweistufige Kategorisierung K1, K2 der im (nicht dargestellten) Herstellungsprozess gefertigten Halbleiterbauelemente H₁ bis H₂₄₈. Die zweistufige Kategorisierung besteht gemäß der Figur aus einer Vor-Kategorisierung K1 und einer prozesstechnisch nachgeschalteten Folge-Kategorisierung K2.

In der Vor-Kategorisierung K1 wird mittels eines Messbausteins 1 zunächst die Größe des Durchlasswiderstands Rₓ des jeweiligen Halbleiterbauteilelements H₁ bis H₂₄₈ gemessen.

Anschließend erfolgt in einem Vergleicherbaustein 3 ein Größenvergleich der Durchlasswiderstände Rₓ der Halbleiterbauelemente H₁ bis H₂₄₈. In einem Zuordnungsbaustein 5 werden, basierend auf der Größe des gemessenen Durchlasswiderstands Rₓ, die Halbleiterbauelemente H₁ bis H₂₄₈ einer Vor-Kategorie bzw. einem Bin B1', B2', B3' zugeordnet. Halbleiterbauelemente mit gleichem oder ähnlichem Durchlasswiderstand Rₓ sind daher derselben Vor-Kategorie B1', B2', B3' zugeordnet. Beispielhaft sind in der Figur die Halbleiterbauelemente H₁ bis H₈₀ der ersten Vor-Kategorie B1' zugeordnet. Das heißt, dass die Halbleiterbauelemente H₁ bis H₈₀ mit zumindest ähnlich großen Durchlasswiderständen Rₓ ausgebildet sind. Entsprechend sind die Halbleiterbauelemente H₈₁ bis H₁₆₀ der zweiten Vor-Kategorie B2' zugeordnet, und die Halbleiterbauelemente H₁₆₁ bis H₂₄₈ der dritten Vor-Kategorie B2` zugeordnet.

Nach erfolgter Vor-Kategorisierung K1 wird die Folge-Kategorisierung K2 durchgeführt. Hierzu werden die Halbleiterbauelemente H₁ bis H₈₀ der ersten Vor-Kategorie B1' einem Signalstrang zugeführt, der aus einem Berechnungsbaustein 7 und einem Zuordnungsbaustein 9 besteht. Im Berechnungsbaustein 7 wird für jedes der Halbleiterbauelemente H₁ bis H₈₀, die der ersten Vor-Kategorie B1' zugeordnet sind, die Abweichung ΔR des gemessenen Durchlasswiderstand Rₓ vom Nominalwert R_{N} ermittelt. Anschließend werden im Zuordnungsbaustein 9 die Halbleiterbauelemente, deren Abweichung ΔR bei -0,3 R_{N} < ΔR ≤ (-0,05) R_{N} liegt, einer ersten Folge-Kategorie B1 zugeordnet. Halbleiterbauelemente, deren Abweichung ΔR bei -0,05 R_{N} < ΔR ≤ + 0,05 R_{N} liegt, werden einer zweiten Folge-Kategorie beziehungsweise B2 zugeordnet. Halbleiterbauelemente, deren Abweichung ΔR bei +0,05 R_{N} < ΔR ≤ 0,3 R_{N} liegt, werden einer dritten Folge-Kategorie B3 zugeordnet.

In gleicher Weise werden auch die in die zweite Vor-Kategorie B2' sortierten Halbleiterbauelemente H₈₁ bis H₁₆₀ und die in die dritte Vor-Kategorie B3' sortierten Halbleiterbauelemente H₁₆₁ bis H₂₄₈ einem identisch aufgebauten Signalbearbeitungspfad zugeführt, so dass dieselbe Folge-Kategorisierung auch mit den Halbleiterbauelementen der zweiten und der dritten Vor-Kategorie B2' und B3' durchgeführt wird.

Beispielhaft können die der ersten Folge-Kategorie B1 zugeordneten Halbleiterbauelemente in Leistungsmodulen mit Einsatz in Hochtemperaturländern verbaut werden. Alternativ dazu können diese in Leistungsmodulen einer Hochstromvariante eines Fahrzeugs hoher Leistungsklasse verbaut werden.

Die der zweiten Folge-Kategorie B2 zugeordneten Halbleiterbauelemente können dagegen in Leistungsmodulen mit Einsatz in gemäßigten Klimazonen verbaut werden. Alternativ dazu können diese in Leistungsmodulen eines Fahrzeugs mittlerer Leistungsklasse verbaut werden.

Die der dritten Folge-Kategorie B3 zugeordneten Halbleiterbauelemente können in Leistungsmodulen mit Einsatz in Niedrigtemperaturländern verbaut werden können. Alternativ dazu können diese in Leistungsmodulen eines Fahrzeugs geringer Leistungsklasse verbaut werden.

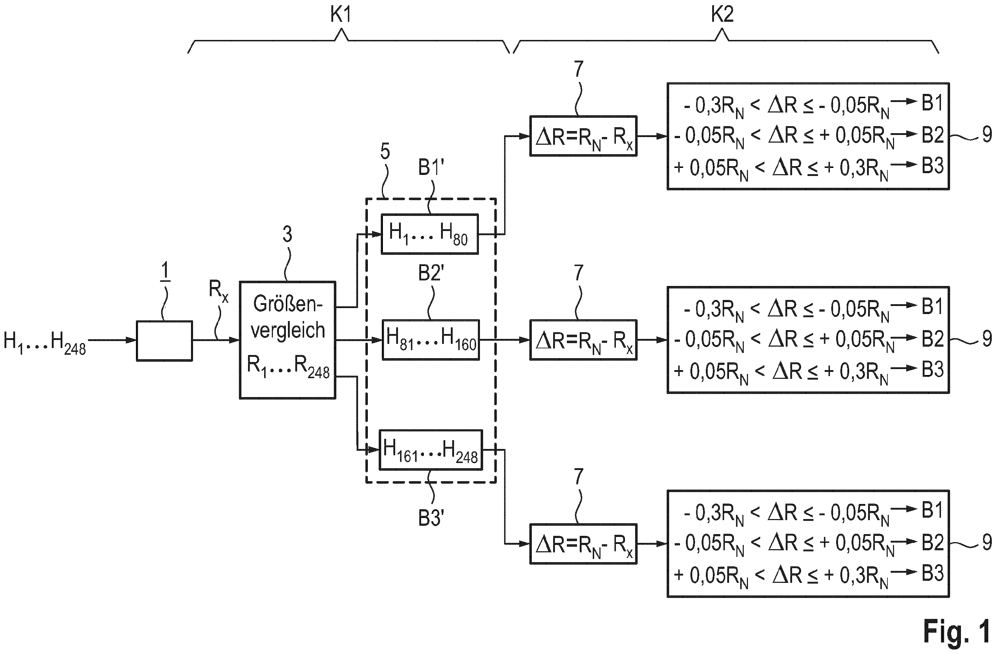

Es wird nochmals hervorgehoben, dass die Erfindung nicht auf das oben anhand der Figur beschriebene Ausführungsbeispiel beschränkt ist. Vielmehr ist die anhand der Figur dargestellte Kategorisierung des Durchlasswiderstands Rₓ ist nur ein Beispiel, während andere Ausführungsbeispiele der Erfindung deutlich davon abweichen können. Ebenso kann die Anzahl der Bins höher oder niedriger sein als in der Figur 1 dargestellt.

### Bezugszeichenliste

- 1: Messbaustein
- 3: Vergleicherbaustein
- 5: Zuordnungsbaustein
- 7: Berechnungsbaustein
- 9: Zuordnungsbaustein
- Rₓ: Durchlasswiderstand
- R_{N}: Nominalwert
- Hₓ: Halbleiterbauelement
- ΔR: Abweichung
- B1', B2', B3': erste bis dritte Vor-Kategorie
- B1, B1, B3: erste bis dritte Folge-Kategorie

## Patentansprüche

1. Test- und Qualitätskontrollverfahren in einem Prozess zur Herstellung von Halbleiterbauelementen (Hₓ), etwa GaN, IGBT, Sic-MOSFET etc., mit einem Messschritt, bei dem die Größe eines Durchlasswiderstands (Rₓ) des jeweiligen Halbleiterbauelements (Hₓ) oder ein damit korrelierender Testparameter gemessen wird, **dadurch gekennzeichnet, dass** das Test- und Qualitätskontrollverfahren einen Auswerteschritt aufweist, bei dem eine Abweichung (ΔR) des Testparameters (Rₓ) von seinem Nominalwert (R_{N}) bestimmt wird, und dass in dem Auswerteschritt eine Kategorisierung (K2) erfolgt, bei der basierend auf der Größe der Abweichung (ΔR) das jeweilige Halbleiterbauelement (Hₓ) einer Kategorie beziehungsweise einem Bin (B1, B2, B3) zugeordnet wird, die den weiteren Einsatz des Halbleiterbauelements (Hₓ) bestimmt.

2. Test- und Qualitätskontrollverf ahren nach Anspruch 1, **dadurch gekennzeichnet, dass** die Halbleiterbauelemente (Hₓ) Sic-MOSFETs sind, die in Pulswechselrichter verbaubar sind.

3. Test- und Qualitätskontrollverfahren nach Anspruch 1 oder 2, **dadurch gekennzeichnet, dass** zur Durchführung der Kategorisierung (K2) ein Auswertebaustein (9) bereitgestellt ist, in dem für jedes Halbleiterbauelement (Hₙ) die Abweichung (ΔR) des Testparameters (Rₓ) vom Nominalwert (R_{N}) ermittelt wird, und ein Zuordnungsbaustein (11) bereitgestellt ist, der die Kategorisierung der Halbleiterbauelemente (Hₓ) vornimmt.

4. Test- und Qualitätskontrollverfahren nach Anspruch 3, **dadurch gekennzeichnet, dass** in dem Zuordnungsbaustein (9)
- Halbleiterbauelemente (Hₓ), deren Abweichung (ΔR) bei -0,3 R_{N} < ΔR ≤ (-0,05) R_{N} liegt, einer ersten Kategorie beziehungsweise Bin (B1) zugeordnet werden,
- Halbleiterbauelemente (Hₓ), deren Abweichung (ΔR) bei -0,05 R_{N} < ΔR ≤ + 0,05 R_{N} liegt, einer zweiten Kategorie beziehungsweise Bin (B2) zugeordnet werden, und
- Halbleiterbauelemente (Hₓ), deren Abweichung (ΔR) bei +0,05 R_{N} < ΔR ≤ 0,3 R_{N} liegt, einer dritten Kategorie beziehungsweise Bin (B3) zugeordnet werden.

5. Test- und Qualitätskontrollverfahren nach Anspruch 4, **dadurch gekennzeichnet, dass** Halbleiterbauelemente (Hₓ), die der ersten Kategorie beziehungsweise Bin (B1) zugeordnet sind, in Leistungsmodulen mit Einsatz in Hochtemperaturländern verbaut werden;
Halbleiterbauelemente (Hₓ), die der zweiten Kategorie beziehungsweise Bin (B2) zugeordnet sind, in Leistungsmodulen mit Einsatz in gemäßigten Klimazonen verbaut werden; und/oder
Halbleiterbauelementen (Hₓ), die der dritten Kategorie beziehungsweise Bin (B3) zugeordnet sind, in Leistungsmodulen mit Einsatz in Niedrigtemperaturländern verbaut werden.

6. Test- und Qualitätskontrollverfahren nach Anspruch 5, **dadurch gekennzeichnet, dass** Halbleiterbauelemente (Hₓ), die der ersten Kategorie beziehungsweise Bin (B1) zugeordnet sind, in Leistungsmodulen einer Hochstromvariante eines Fahrzeugs hoher Leistungsklasse verbaut werden;
Halbleiterbauelemente (Hₓ), die der zweiten Kategorie beziehungsweise Bin (B2) zugeordnet sind, in Leistungsmodulen eines Fahrzeugs mittlerer Leistungsklasse verbaut werden; und/oder
Halbleiterbauelemente (Hₓ), die der dritten Kategorie beziehungsweise Bin (B3) zugeordnet sind, in Leistungsmodulen eines Fahrzeugs geringer Leistungsklasse verbaut werden.

7. Test- und Qualitätskontrollverfahren nach Anspruch 4, 5 oder 6, **dadurch gekennzeichnet, dass**
Halbleiterbauelemente (Hₓ), die der ersten Kategorie beziehungsweise Bin (B1) zugeordnet sind, in Pulswechselrichter verbaut werden;
Halbleiterbauelemente (Hₓ), die der zweiten Kategorie beziehungsweise Bin (B2) zugeordnet sind, in DC/DC-Wandler verbaut werden; und/oder
Halbleiterbauelemente (Hₓ), die der dritten Kategorie beziehungsweise Bin (B2) zugeordnet sind, in Ladesäulen verbaut werden.

8. Test- und Qualitätskontrollverfahren nach einem der Ansprüche 4 bis 7, **dadurch gekennzeichnet, dass** jegliche Kombination von Halbleiterbauelementen (Hₓ) im Pulswechselrichter von elektrisch betriebenen Fahrzeugen gleichen Fahrzeugtyps zu unterschiedlichen Leistungsangaben der Fahrzeuge führt, und dass die entsprechend gekennzeichneten unterschiedlichen Fahrzeug-Leistungsangaben als Kaufhilfe einem Fahrzeugkäufer angeboten werden.

9. Test- und Qualitätskontrollverfahren nach einem der vorhergehenden Ansprüche,
**dadurch gekennzeichnet, dass** in dem Auswerteschritt eine zweistufige Kategorisierung (K1, K2) durchgeführt wird, bei der in einer weiteren Kategorisierung (K1) basierend auf der Größe des gemessenen Testparameters (Rₓ) das jeweilige Halbleiterbauelement (Hₓ) einer Kategorie (B1', B2', B3') derart zugeordnet wird, dass die Halbleiterbauelemente (Hₓ), deren Testparameter (Rₓ) gleiche oder ähnliche Größen aufweisen, derselben Kategorie (B1', B2', B3') zugeordnet sind.

10. Test- und Qualitätskontrollverfahren nach Anspruch 9, **dadurch gekennzeichnet, dass** in der zweistufigen Kategorisierung die Kategorisierung (K1) basierend auf der Größe des gemessenen Testparameters (Rₓ) eine Vor-Kategorisierung ist, und dass prozesstechnisch nachgeschaltet die Kategorisierung (K2) basierend auf der Größe der Abweichung (ΔR) vom Nominalwert (R_{N}) als Folge-Kategorisierung durchgeführt wird.
